Europäisches Patentamt

European Patent Office

Office européen des brevets

(11) Publication number: **0 114 491**
**B1**

(12) **EUROPEAN PATENT SPECIFICATION**

(45) Date of publication of patent specification: **15.03.89**

(21) Application number: **83307727.4**

(22) Date of filing: **19.12.83**

(51) Int. Cl.⁴: **H 01 L 27/08**

(54) Semiconductor integrated circuit device with output stage.

(30) Priority: **28.12.82 JP 228693/82**

(43) Date of publication of application:
**01.08.84 Bulletin 84/31**

(45) Publication of the grant of the patent:
**15.03.89 Bulletin 89/11**

(84) Designated Contracting States:
**DE FR GB**

(56) References cited:
**EP-A-0 033 028**
**DE-A-3 107 543**

(73) Proprietor: **FUJITSU LIMITED**
**1015, Kamikodanaka Nakahara-ku**
**Kawasaki-shi Kanagawa 211 (JP)**

(72) Inventor: **Shirato, Takehide**
**6-26, Sengen-cho**
**Hiratsuka-shi Kanagawa 254 (JP)**
Inventor: **Inaba, Touru**
**539-50, Kamikashio Totsuka-ku**
**Yokohama-shi Kanagawa 244 (JP)**

(74) Representative: **Rackham, Stephen Neil et al**
**GILL JENNINGS & EVERY 53-64 Chancery Lane**
**London WC2A 1HN (GB)**

EP 0 114 491 B1

Courier Press, Leamington Spa, England.

## Description

The present invention relates to a semiconductor integrated circuit device, particularly a device comprising a first metal insulator semiconductor (MIS) type field effect transistor (FET) for forming an internal circuit and a second MIS FET with a medium junction sustaining voltage for forming an output stage.

Electrical apparatus driven by a 12 V power source are often used and when it is desired directly to couple a semiconductor integrated circuit device operating with a standard 5 V power source to such apparatus at its output stage to simplify the circuit system. Although, such a semiconductor integrated circuit device need not have a junction sustaining voltage as high as 30 V to 40 V, as is usually used in devices for driving fluorescent display devices, it has to have a medium junction sustaining voltage which is usually as high as 15 V to 16 V at its output stage.

We have found that the sustaining voltage is determined by the electric field concentration between the gate electrode and the drain diffusion region and can be enhanced by an increase in the thickness of the gate oxide layer. However, if the channel length is made shorter than a predetermined length, as often happens during mass production of the devices, the so-called punch-through phenomenon occurs. This increases the drain current and, consequently, lowers the junction sustaining voltage. In addition, such semiconductor devices have to be used in a wide temperature range without deterioration of the performance.

For these reasons, it has become necessary to provide mass-produced semiconductor devices with a predetermined sustaining voltage of 19 V to 20 V, to secure the medium junction sustaining voltage of an output stage.

While the so-called offset gate structure metal oxide semiconductor (MOS) FET exhibits a high junction sustaining voltage of approximately 40 V, the yield of chips obtained per wafer is low and the size of the chip is necessarily larger than that of the regular devices because it requires rather complicated process steps and structure. This is also a disadvantage of the so-called 4 µm rule integrated circuits, in which all of the smallest devices have a 4 µm channel length, although this device can have a suitable medium junction sustaining voltage of, for example, 16 V to 20 V.

DE—A—3107543 describes a semiconductor integrated circuit device comprising a first MIS FET for forming an internal circuit for a device operating at a standard voltage such as 5 volts and a second MIS FET which is adapted to receive a voltage higher than the standard voltage, the second MIS FET having a channel length greater than that of the first MIS FET and having a gate insulator thickness greater than that of the first MIS FET. The semiconductor device is an EPROM and the second MIS FET handles the write voltage for writing information into the memory cells. This write voltage is typically 25 volts and is applied to the gate and drain. Accordingly both the channel length and the gate insulator thickness are increased to increase the breakdown voltage of the second MIS FET.

The claimed invention has the advantage that it exhibits no deterioration in the junction sustaining voltage due to the punch-through phenomenon in spite of possible fluctuations in its manufacturing process steps. Another advantage is that the device is produced by a small number of production steps and can be mass-produced with a high yield.

A particular embodiment of a device in accordance with this invention will now be described and contrasted with the prior art with reference to the accompanying drawings, in which:—

Figure 1 is a graph of the relationship between the voltage $V_{DS}$ and the current $I_{DS}$ of an MOS FET;

Figure 2 is a section through a common MOS FET;

Figure 3 is a section through an offset gate structure MOS FET; and

Figure 4 is a series of sectional views illustrating the method of producing a semiconductor integrated circuit device comprising two MOS FETs in accordance with the present invention.

Before describing the preferred embodiments of the present invention, it is necessary to explain in detail the devices of the prior art; in order to show the advantages of the present invention over the prior art. This explanation is made with reference to the accompanying drawings.

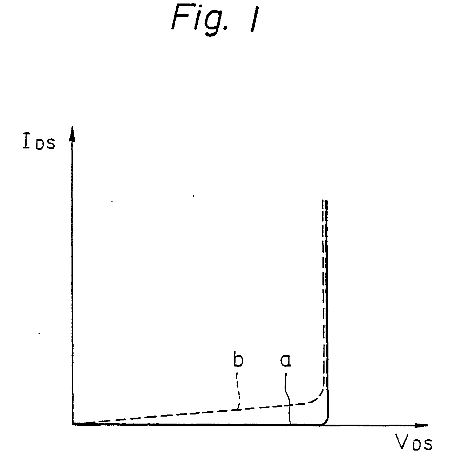

As shown in Fig. 1, the drain current $I_{DS}$ between the drain electrode and the source electrode rapidly increases, as the drain voltage $V_{DS}$ therebetween increases up to a complete junction breakdown voltage where an avalanche breakdown occurs (curve a). It is commonly known that although such a breakdown voltage is determined by the impurity concentration profile at the junction, it is lowered by the electric field concentration between the gate electrode and the drain diffusion region and can be enhanced with the increase of thickness t of the gate oxide layer. If the length L of the gate electrode is selected to be shorter than a predetermined length, a so-called punch through phenomenon will occur, which increases the drain current $I_{DS}$ and, consequently, lowers the junction sustaining voltage (curve b). It should be noted that the junction sustaining voltage in practice should be defined by a relatively low drain current even though a completed avalanche breakdown often occurs at much higher voltages. In this specification, the drain junction sustaining voltage is defined as a voltage value at which the junction allows a drain current of 1µA under the gate bias voltage of zero.

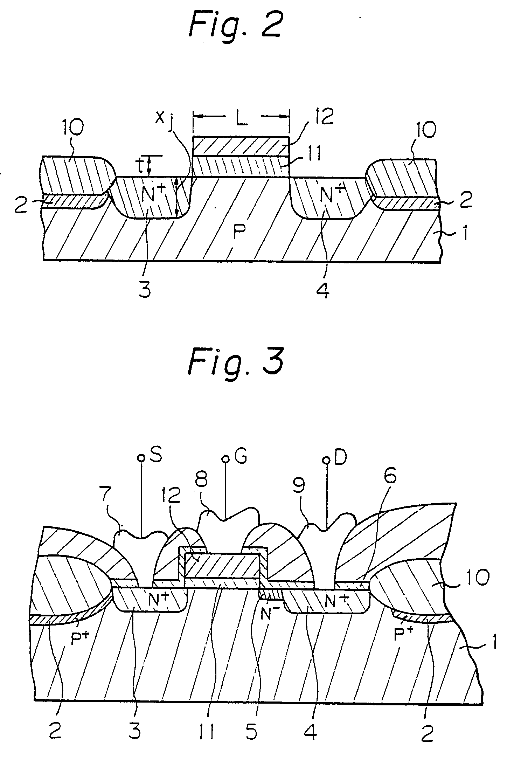

Generally, a silicon FET is electrically isolated from adjacent devices formed on the same silicon substrate 1 by means of channel cut layers 2 on which a field oxide layer 10 is formed, and comprises a source, gate, and drain regions, which correspond to a high concentration N-type region 3, a region under a gate insulator layer 11 for forming an inverted conduction channel between source and drain under the control of the gate voltage in the transistor action, a polysilicon layer 12, and another high concentration N-type region 4, respectively (Fig. 2).

A thin oxide layer 6 covers the source and drain regions 3 and 4 and the polysilicon layer 12, on which the source and drain electrodes 7 and 9 and the gate electrode 8 are mounted through the windows opened in the oxide layer 6, respectively (Fig. 3).

It is commonly known that a semiconductor device exhibits a medium junction sustaining voltage of 15 V to 16 V, where the device has a 3 μm channel length L, a 40 nm (400 Å) gate oxide layer thickness t, and a 0.4 μm junction depth $X_j$ in the source and drain regions (Fig. 2). However, in the commercial mass production of such semiconductor devices, some are apt to have a channel length L which is shorter than the predetermined length. In addition, practically, such semiconductor devices have to be used in a wide temperature range without deterioration of their performance. Therefore, it is necessary that mass-produced semiconductor devices are provided with a predetermined sustaining voltage of 19 V to 20 V, so as to secure a medium junction sustaining voltage for the purpose of direct coupling with the 12 V power source system.

In a so-called offset gate structure MOS FET (Fig. 3), the high concentration N-type region 4 is separated from the gate region via a low concentration N-type region 5. Thus, the drain region 4 has an offset structure, and, consequently, exhibits a high junction sustaining voltage of about 40 V. The drain region 4 is isolated from the channel cut layer 2. However, these structures inevitably increase the production steps, making necessary, for example, ion implantation for forming the low concentration N-type region 5, and also masking for forming this region 5 and separating the region 4 from the channel cut layer 2. In addition, the yield of chips per wafer is lowered because the chip size becomes larger than that of the regular devices.

An integrated circuit device for directly coupling with 12 V systems need not be guaranteed to exhibit such a high junction sustaining voltage as 40 V, a medium sustaining voltage of 16 V to 20 V at least at the output stage for the direct coupling is sufficient. Such a medium junction sustaining voltage has been conveniently achieved in so-called 4 μm rule integrated circuits, in which all of the least channel length devices have a 4 μm channel length L, an about 70 nm (700 Å) gate oxide layer thickness t, and a 0.6 μm junction depth $X_j$ of the high concentration N-type regions 3 and 4. However, the yield of chips per wafer is unavoidably reduced due to the relatively large dimension of the least size devices.

According to the present invention, there is provided a semiconductor integrated circuit device comprising a first MIS FET for forming an internal circuit and a second MIS FET for forming an output stage circuit, characterized in that the second MIS FET has a channel length greater than that of the first MIS FET and has a gate insulator thickness greater than that of the first MIS FET. The present invention is advantageous in that the first and second MIS FETs have the same junction depth in the drain and source regions thereof which simplifies the necessary process steps for manufacturing the same.

As for an output-stage MIS FET for the direct coupling with the 12 V system according to the present invention, the junction sustaining voltage is enhanced by increasing the thickness of the gate oxide layer so as to reduce the electric field concentration between the gate electrode and the high concentration N-type drain region; the punch-through phenomenon is eliminated by increasing the channel length, and thus, the output-stage MIS FET is guaranteed to exhibit a medium junction sustaining voltage. On the other hand, an MIS FET which is not in an output stage has a standard junction sustaining voltage.

In addition, the high concentration N-type drain and source regions may be formed by a single ion implantation, where the depths of the drain and source regions are equal to each other.

Although the following description refers to an integrated circuit device using an MOS FET, it will be clear to a person skilled in the art that the present invention can also be valid to those using MIS FETs.

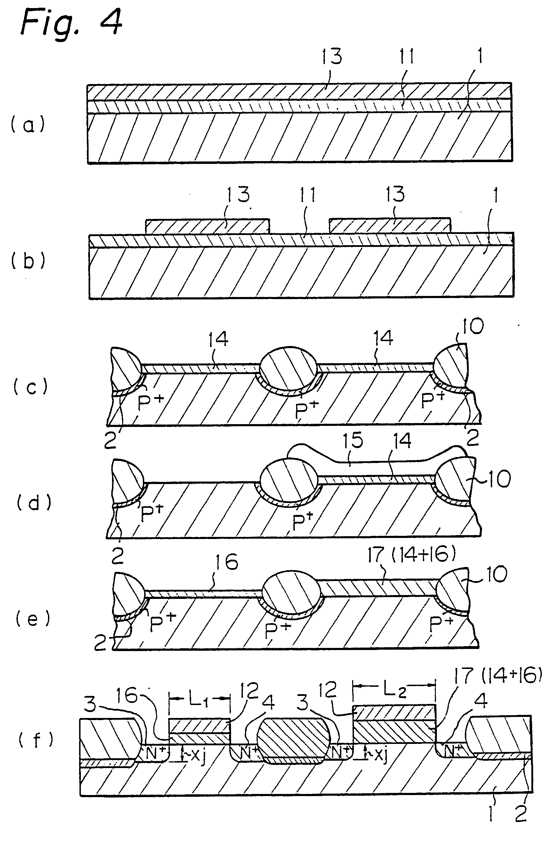

Here the present invention will be described in detail, referring to Fig. 4.

The surface of a silicon substrate 1 is oxidized so as to form a 50 nm (500 Å) thick silicon oxide layer 11, and a 100 nm (1000 Å) thick silicon nitride layer 13 is deposited on the oxide layer 11 (Fig. a).

The nitride layer 13 is patterned using a first photoresist mask (not shown), thus, windows are opened (Fig. b).

Channel cut regions 2 are formed by ion implantation using the first photoresist mask, which is then removed. Field oxide layers 10 are formed by a selective thermal oxidation using the nitride layer 13 as a mask. After removing the nitride layer 13 and the oxide layer 11, a 40 nm (400 Å) thick lower gate oxide layer 14 is formed (Fig. c).

A second photoresist 15 is selectively formed to form an etching mask which exposes a first semiconductor device area and covers a second semiconductor device area. A portion of the lower gate oxide layer 14 is removed by etching so as to expose the area of a first semiconductor device which will exhibit a standard junction sustaining voltage (Fig. d).

After removing the second photoresist 15, a 40 nm (400 Å) thick oxide layer 16 is formed on the surface of the area of the first semiconductor device by a thermal oxidation, by which the oxide layer 14 will grow to the thickness of 70 nm (700 Å). Thus, a 40 nm (400 Å) thick gate oxide layer 16 is formed in the area of the first semiconductor device, and a 70 nm (700 Å) thick gate oxide layer 17 is formed in the area of the second semiconductor device, so as to exhibit a medium junction sustaining voltage (Fig. e). Ion implantation is carried out to control the threshold voltage.

A polysilicon layer 12 is deposited and is patterned so as to form the gate regions of the first and second semiconductor devices with the lengths $L_1$ and $L_2$, which are 3 µm and 4 µm, respectively.

After removing portions of the oxide layers 16 and 17 which do not cover the gate regions, an N-type impurity is diffused so as to form the source and drain regions 3 and 4. Where the diffusion depth $X_j$ in both regions is the same, e.g., 0.4 µm, the first and second semiconductor devices may be accomplished in a single diffusion step (Fig. f).

Thus, according to the present invention, there is provided a semiconductor integrated circuit device comprising an output-stage MIS FET guaranteed to exhibit a medium junction sustaining voltage and an internal circuit MIS FET guaranteed to exhibit a standard junction sustaining voltage, which device can be mass-produced in a simple production process.

## Claims

1. A semiconductor integrated circuit device comprising a first MIS FET (3, 4, 12, 16) for forming an internal circuit for a device operating at a standard voltage of 5 volts and a second MIS FET (3, 4, 12, 17) which is adapted to receive a voltage higher than the standard voltage, the second MIS FET (3, 4, 12, 17) having a channel length $(L_2)$ greater than that $(L_1)$ of the first MIS FET (3, 4, 12, 16) and having a gate insulator (17) thickness greater than that (16) of the first MIS FET (3, 4, 12, 16), characterised in that the second MIS FET forms an output stage circuit directly coupled to an external voltage source of 12 volts, the second MIS FET (3, 4, 12, 17) providing a reduced drain current characteristic at a drain voltage substantially lower than its drain breakdown voltage.

2. A semiconductor integrated circuit device according to claim 1, in which the first (3, 4, 12, 16) and second (3, 4, 12, 17) MIS FETs have the same depth $(X_j)$ of impurity diffusion in their drain and source regions.

## Patentansprüche

1. Integrierte Halbleiterschaltungsvorrichtung mit einem ersten MIS-FET (3, 4, 12, 16), um eine interne Schaltung für eine Vorrichtung zu bilden, die mit einer Standardspannung von 5 Volt arbeitet, und einem zweiten MIS-FET (3, 4, 12, 17), der angepaßt ist, um eine höhere Spannung als die Standardspannung zu erzeugen, wobei der zweite MIS-FET (3, 4, 12, 17) eine erste Kanallänge $(L_2)$ hat, die größer als $(L_1)$ des ersten MIS-FET 3, 4, 12, 16) ist, und einen Gateisolator (17) hat, dessen Dicke größer als jene (16) des ersten MIS-FET (3, 4, 12, 16) ist, dadurch gekennzeichnet, daß der zweite MIS-FET eine Ausgangsstufenschaltung bildet, die direkt mit einer externen Spannungsquelle von 12 Volt gekoppelt ist, der zweite MIS-FET (3, 4, 12, 17) eine reduzierte Drainstromcharakteristik bei einer Drainspannung hat, die im wesentlichen niedriger als ihre Draindurchbruchsspannung ist.

2. Integrierte Halbleitersschaltungsvorrichtung nach Anspruch 1, bei der die ersten (3, 4, 12, 16) und zweiten (3, 4, 12, 17) MIS-FETs dieselbe Tiefe $(X_j)$ der Verungeriniigungsdiffusion in ihren Drain- und Sourcebereichen haben.

## Revendications

1. Dispositif à circuit intégré à semiconducteurs comprenant un premier MIS FET (3, 4, 12, 16) destiné à former un circuit interne pour un dispositif fonctionnant à une tension normalisée de 5 V et un deuxième MIS FET (3, 4, 12, 17) qui est conçu pour recevoir une tension supérieure à la tension normalisée, le deuxième MIS FET (3, 4, 12, 17) ayant une longueur de canal $(L_2)$ supérieure à celle $(L_1)$ du premier MIS FET (3, 4, 12, 16) et ayant une épaisseur d'isolant de grille (17) qui est supérieure à celle (16) du premier MIS FET (3, 4, 12, 16), caractérisé en ce que le deuxième MIS FET forme un circuit d'étage de sortie directement couplé à une source de tension externe de 12 V, le deuxième MIS FET (3, 4, 12, 17) produisant une caractéristique de courant de drain réduit pour une tension de drain sensiblement inférieure à sa tension de rupture de drain.

2. Dispositif à circuit intégré à semiconducteurs selon la revendication 1, dans lequel le premier MIS FET (3, 4, 12, 16) et le deuxième MIS FET (3, 4, 12, 17) ont la même profondeur $(X_j)$ de diffusion d'impureté dans leurs régions de drain et de source.

# Fig. 1

## Fig. 2

## Fig. 3

# Fig. 4

( a )

( b )

( c )

( d )

( e )

( f )